# EUROPÄISCHE PATENTSCHRIFT

(11) **EP 1 782 484 B1**
(45) Veröffentlichungstag und Bekanntmachung des Hinweises auf die Patenterteilung: **07.05.2008**
(21) Anmeldenummer: 05772708.3
(22) Anmeldetag: 18.08.2005
(51) Int. Cl.: H01L 39/24

(54) **VERFAHREN ZUR HERSTELLUNG EINES BANDFÖRMIGEN HOCHTEMPERATUR-SUPRALEITERS MIT CSD-SUPRALEITERBESCHICHTUNG**
METHOD OF PRODUCING A STRIP-SHAPED HIGH-TEMPERTURE SUPERCONDUCTOR WITH CSD SUPERCONDUCTOR COATING
PROCEDE DE PRODUCTION D'UN SUPRACONDUCTEUR A HAUTE TEMPERATURE, SOUS FORME DE BANDES, AYANT UN REVETEMENT SUPRACONDUCTEUR DE TYPE CSD

(30) Priorität: 25.08.2004 DE 102004041053
(43) Veröffentlichungstag der Anmeldung: 09.05.2007
(73) Patentinhaber: Trithor GmbH, 53359 Rheinbach (DE)
(72) Erfinder: BÄCKER, Michael, 50670 Köln (DE); SCHLOBACH, Brigitte, 01728 Bannewitz (DE); KNOTH, Kerstin, 01309 Dresden (DE); SCHÜPP-NIEWA, Barbara, 85399 Hallbergmoos (DE); HOLZAPFEL, Bernhard, 01069 Dresden (DE); FALTER, Martina, 53913 Swisttal-Buschhoven (DE)
(74) Vertreter: Prietsch, Reiner
(86) Internationale Anmeldenummer: PCT/EP2005/008962
(87) Internationale Veröffentlichungsnummer: WO 2006/021370

(56) Entgegenhaltungen:
- US-A1- 2002 139 960
- US-B1- 6 562 761
- TAKAHASHI Y ET AL: "Preparation of YBCO films on CeO2/Zr2Gd2O7/Hastelloy tapes by the TFA-MOD method" PHYSICA C, NORTH-HOLLAND PUBLISHING, AMSTERDAM, NL, Bd. 378-381, Oktober 2002 (2002-10), Seiten 1024-1027, XP004383043 ISSN: 0921-4534
- PARANTHAMAN M ET AL: "Fabrication of long lengths of YBCO coated conductors using a continuous reel-to-reel dip-coating unit" IEEE TRANSACTIONS ON APPLIED SUPERCONDUCTIVITY IEEE USA, Bd. 11, Nr. 1, März 2001 (2001-03), Seiten 3146-3149, XP002353591 ISSN: 1051-8223 in der Anmeldung erwähnt
- ARAKI T ET AL: "Review of a chemical approach to YBa2Cu3O7-x-coated superconductors - metalorganic deposition using trifluoroacetates" SUPERCONDUCTOR SCIENCE & TECHNOLOGY IOP PUBLISHING UK, Bd. 16, Nr. 11, November 2003 (2003-11), Seiten R71-R94, XP002353592 ISSN: 0953-2048 in der Anmeldung erwähnt
- DAWLEY J T ET AL: "Thick Sol-Gel Derived YBa2Cu3O7-d Films" IEEE TRANSACTIONS ON APPLIED SUPERCONDUCTIVITY IEEE USA, Bd. 11, Nr. 1, März 2001 (2001-03), Seiten 2873-2876, XP002353593 ISSN: 1051-8223
- GLAVEE G N ET AL: "Low temperature preparation of BaCeO3 and Ce0.75Zr0.25O2 thin films using sol-gel processing techniques" MATERIALS RESEARCH BULLETIN, PERGAMON PRESS, NEW YORK, US, Bd. 34, Nr. 5, 15. März 1999 (1999-03-15), Seiten 817-825, XP004179918 ISSN: 0025-5408
- SHETH A ET AL: "Bench scale evaluation of batch mode dip-coating of sol-gel LaAlO3 buffer material" IEEE TRANSACTIONS ON APPLIED SUPERCONDUCTIVITY, IEEE SERVICE CENTER, LOS ALAMITOS, CA, US, Bd. 9, Nr. 2, Juni 1999 (1999-06), Seiten 1514-1518, XP002164574 ISSN: 1051-8223

## Beschreibung

### Technisches Gebiet

Die Erfindung betrifft ein Verfahren zur Herstellung hochtexturierter, bandförmiger Hochtemperatur-Supraleiter.

Nachfolgend wird auf die Dokumente D1-D12 bezug genommen:
- D1:: S. Beauquis, C. Jimenez, F. Weiss, in: High Temperature Superconductivity 1: Materials, A.V. Narlikar (Ed.), Springer-Verlag, 2004, 115-167.
- D2:: A.P. Malozemoff, S. Annavarapu, L. Fritzemeier, Q. Li, V. Prunier, M. Rupich, C. Thieme, W. Zhang, A. Goyal, M. Paranthaman, D.F. Lee, Supercond. Sci. Technol. 13 (2000) 473-476.
- D3:: DE 101 43 680 Verfahren zur Herstellung von Metallbändern mit hochgradiger Würfeltextur; J. Eickemeyer, D. Selbmann, R. Opitz.
- D4:: CN 1 117 879 Metallischer Werkstoff auf Nickelbasis und Verfahren zu dessen Herstellung; J. Eickemeyer, D. Selbmann, R. Opitz, B. Holzapfel.
- D5:: DE 1000 05 861 Metallischer Werkstoff auf Nickelbasis und Verfahren zu dessen Herstellung; J. Eickemeyer, D. Selbmann, R. Opitz, B. Holzapfel.
- D6:: A. Gupta, R. Jagannathan, E.I. Cooper, E.A. Giess, J.I. Landman, B.W. Hussey; Appl. Phys. Lett. 52 (1988) 2077-2079.
- D7:: P.C. MCIntyre, M.J. Cima, M. Fai Ng; J. Appl. Phys. 68 (1990) 4183-4187.
- D8:: J.A. Smith, M.J. Cima, N. Sonnenberg; IEEE Trans. on Appl. Supercond. 9 (1999) 1531-1534.
- D9:: M. Paranthaman, T.G. Chirayil, S. Sathyamurthy, D.B. Beach, A. Goyal, F.A. List, D.F. Lee, X. Cui, S.W. Lu, B. Kang, E.D. Specht, P.M. Martin, D.M. Kroeger, R. Feenstra, C. Cantoni, D.K. Christen, IEEE Trans. on Appl. Supercond. 11 (2001) 3146-3149.
- D10:: T. Araki, I. Hirabayashi; Supercond. Sci. Technol. 16 (2003) R71-R94.
- D11:: M. Leskelä, H. Mölsä, L. Niinistö; Supercond. Sci. Technol. 6, 1993, 627-656.
- D12:: Y. Takahashi, Y.Aoki, T. Hasegawa Y.Jijima , T.Saito, I. Hirabayashi ,T.Honjo.Y.Yoshida, Y.Takai, Y.Shiohara; Physica C 378-381 (2002) 1024-1027

### Stand der Technik

Einige Kupratsupraleiter sind bereits oberhalb der Siedetemperatur von flüssigem Stickstoff (77K) supraleitend. Die Kupratsupraleiter werden deshalb auch Hochtemperatur-Supraleiter (HTSL) genannt. Allerdings haben diese Supraleiter schlechte mechanische Eigenschaften. Ein Ansatz, um die damit verbundenen Probleme zu überwinden, ist die Entwicklung von Bandleitern. Bandleiter (Band-HTSL oder bandförmige HTSL) sind sogenannte Coated Conductors, die eine supraleitende Funktionsschicht haben, die über ein spezielles Verfahren auf ein bandförmiges Substrat aufgebracht wird. Als Funktionsschicht kann z.B. Yttrium-Barium-Kupfer-Oxid YBa₂Cu₃Oₓ (YBCO) zum Einsatz kommen.

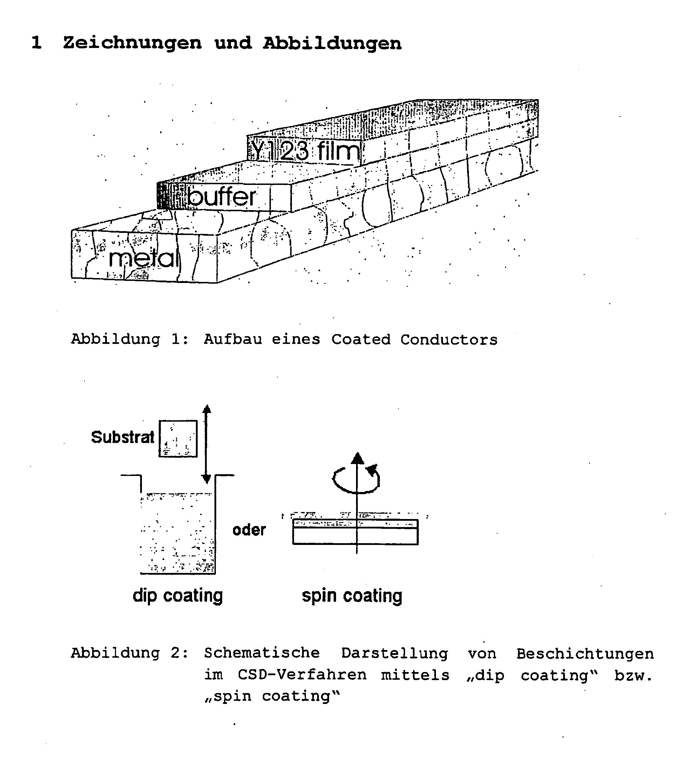

Diese Bandleiter weisen i.a. eine Struktur aus Metallsubstrat, Pufferschicht und supraleitender Schicht auf (vgl. Abbildung 1). Die Wirtschaftlichkeit des Herstellungsprozesses wird maßgeblich durch das Abscheideverfahren sowie durch die supraleitenden Eigenschaften bestimmt [D1,D2].

Hauptschwierigkeit der Produktion von Coated Conductors ist die Tatsache, dass die HTSL-Schicht eine extrem hohe Textur, d.h. kristallographische Orientierung aufweisen muss. Die einzelnen Kristallite der Schicht dürfen nur um einen minimalen Betrag gegeneinander verkippt sein, da sonst die supraleitenden Eigenschaften massiv beeinträchtigt werden.

Um einen solchen hohen Texturgrad zu erreichen, werden zwei unterschiedliche Herstellungsansätze verfolgt. Beiden Ansätzen ist gemein, dass vor dem Abscheiden der Supraleiterschicht eine texturierte Pufferschicht erzeugt wird, die ihre Textur, d.h. Orientierung, an den Supraleiter bei dessen Abscheidung überträgt. Bei beiden Ansätzen werden Metallsubstrate verwendet, weil nur so die für die spätere Verwendung in elektrotechnischen Anwendungen erforderliche Festigkeit der Bandleiter erreicht werden kann. Im ersten Ansatz wird von einem untexturierten, kristallographisch nicht orientierten, metallischen Substrat ausgegangen. Dabei wird zumeist eine Hastelloy-Legierung verwendet. Auf dieses untexturierte Substrat wird anschließend die Pufferschicht mit einer Orientierung aufgebracht. Eine solche gerichtete Abscheidung kann nur mittels physikalischer Beschichtungsverfahren, beispielsweise Ion Beam Assisted Deposition (IBAD) und Inclined Substrate Deposition (ISD), im Hochvakuum erfolgen. Entscheidende Nachteile dieser Verfahren sind der hohe apparative Aufwand, z.B. durch das zu verwendende Hochvakuum und die nur geringen Abscheideraten. Im zweiten Ansatz wird bereits das Metallsubstrat durch spezielle Umform- und Temperaturbehandlungsprozesse texturiert (D3, D4, D5). Die Textur des Substrates kann damit auf die Pufferschicht und von dort auf die Supraleiterschicht übertragen werden. Vorteil dieser Methode ist, dass keine gerichteten Abscheideverfahren angewendet werden müssen. Hier können u.a. sowohl physikalische Verfahren wie Pulsed Laser Deposition (PLD) und Thermische Co-Verdampfung (Thermal Co-Evaporation, TCE) als auch chemische Verfahren wie Chemical Solution Deposition (CSD) und Metal-Organic Chemical Vapour Deposition (MOCVD) eingesetzt werden. Für die genannten physikalischen Verfahren gilt prinzipiell das zum ersten Verfahrensansatz Gesagte, wobei die Abscheideraten der physikalischen Verfahren mit ungerichteter Abscheidung deutlich höher sind.

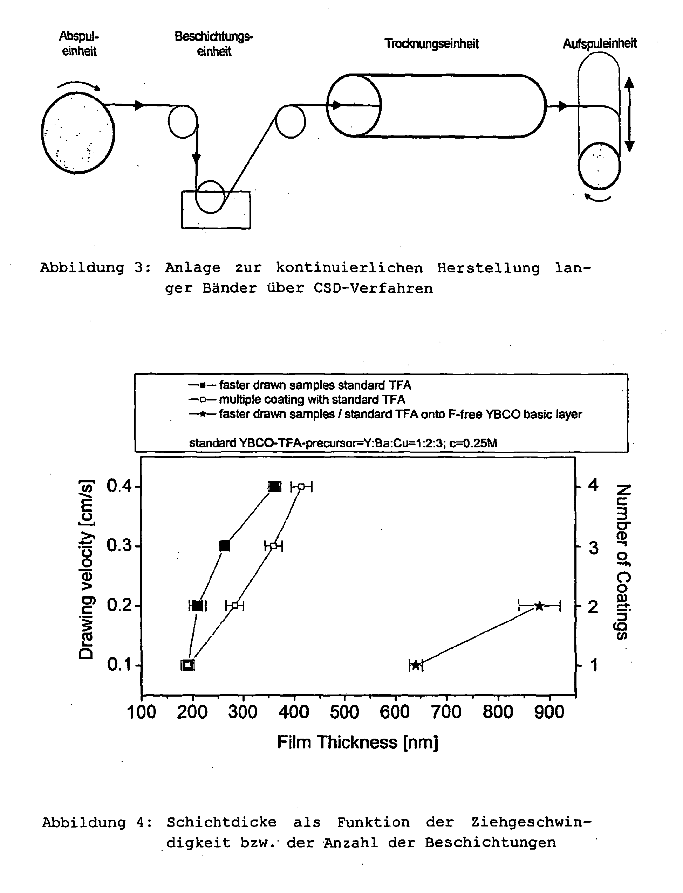

Besonders ökonomisch bezüglich Anlagen- als auch Betriebskosten sind chemische Beschichtungsverfahren, da diese i.a. bei Normaldruck, d.h. ohne Hochvakuum, arbeiten und eine deutlich höhere Abscheiderate ermöglichen. Daher stehen weltweit CSD-Verfahren (Chemical Solution Deposition), die im Gegensatz zu physikalischen Beschichtungsmethoden bei Normaldruck erfolgen, im Mittelpunkt zahlreicher Entwicklungen. Im Labormaßstab erfolgt die Beschichtung mit CSD-Verfahren als "dip coating", indem das Substrat in eine Lösung eingetaucht und wieder herausgezogen wird, oder als "spin coating". Hier werden einige Tropfen der Lösung auf ein Substrat aufgebracht und durch Rotation des Substrats verteilt (vgl. Abb. 2). Zur Produktion von größeren Längen kann das Substratband durch eine Beschichtungslösung gezogen und anschließend in einem Ofen getrocknet werden. Eine schematische Darstellung einer solchen Anlage ist Abbildung 3 zu entnehmen. Bei CSD-Verfahren erfolgt die Umsetzung zur eigentlichen kristallinen Schicht in mehreren Schritten. Zunächst wird das Substrat beschichtet und anschließend getrocknet, d.h. das Lösungsmittel wird entfernt. Dabei entsteht eine i.a. amorphe Schicht aus organischen und/oder anorganischen Metallsalzen. Die zersetzbaren Anteile der Salze werden in einem anschließenden Schritt pyrolysiert. Die pyrolysierte Schicht wird in einem letzten Glühschritt zur endgültigen Schicht kristallisiert.

Diese Teilschritte können sowohl nacheinander als auch mittels eines Temperaturprogramms innerhalb einer einzigen Glühbehandlung durchgeführt werden.

Die für eine Beurteilung der Ökonomie eines Coated Conductors bzw. dessen Herstellverfahrens betrachteten supraleitenden Eigenschaften sind sowohl die kritische Stromdichte Jc als auch der kritische Strom Ic. Typischerweise werden hier die Werte bei 77 K (Siedetemperatur von Stickstoff) mit einem Kriterium von 1 µV/cm Spannungsabfall zugrunde gelegt. Alle im weiteren Verlauf angegebenen Werte für die kritischen supraleitenden Eigenschaften beziehen sich auf diese Temperatur und dieses Kriterium. Die Textur der supraleitenden Schicht ist, wie oben beschrieben, maßgeblich verantwortlich für deren Güte, beeinflusst also insbesondere die kritische Stromdichte Jc. Aktuell erreichbare typische Werte für YBCO Schichten, die mittels CSD Verfahren auf verschiedenen Pufferschichten abgeschieden wurden, sind Stromdichten von ca. 2 MA/cm². Dabei ist es unerheblich, welcher Ansatz gemäß der oben beschriebenen Aufbaumöglichkeiten für Coated Conductors gewählt wurde. Mögliche Pufferschichtmaterialien können Yttrium-stabilisiertes Zirkonoxid, Gadolinium-Zirkonat, Yttriumoxid, Lanthan-Aluminat, Lanthan-Zirkonat, Strontium-Titanat, Nickeloxid, Ceroxid, Magnesiumoxid, Lanthan-Manganat, Strontium-Ruthenat und viele andere mehr sein. Auch Schichtkombinationen aus mehreren unterschiedlichen Materialen sind möglich. Die höchsten Werte für die kritischen Stromdichten von CSD-YBCO-Schichten werden aktuell auf physikalisch hergestellten Pufferschichten erzielt.

Zwar ist die kritische Stromdichte ein zentrales Merkmal eines Coated Conductors, jedoch ist dieses Merkmal für die Beurteilung der supraleitenden Performance nicht ausreichend, da dieser Wert nichts über den absoluten kritischen Strom Ic aussagt. Ein hoher absoluter kritischer Strom lässt sich nur durch verhältnismäßig dicke, hoch-texturierte YBCO Schichten, d.h.

Schichten mit hoher kritischer Stromdichte Jc, erreichen. Das Erreichen eines hohen Texturgrades über die gesamte Dicke einer supraleitenden Schicht ist besonders bei Schichten, die über ein CSD Verfahren abgeschieden wurden, sehr schwierig. Während dünne Schichten im Bereich von bis zu 500 nm eine sehr gute Textur und damit hohe Jc-Werte aufweisen, verringert sich Jc bei dickeren Schichten, die konventionell mittels CSD hergestellt wurden, vor allem an der Oberfläche dramatisch. Somit ist es mit den aktuellen CSD Verfahren nicht möglich, Coated Conductors mit einem sehr hohen Ic herzustellen.

Dass dies nicht möglich ist, liegt zu einem großen Teil an den aktuell verwendeten Lösungsmittel- und Precursorsystemen für die Abscheidung der YBCO-Schichten mittels CSD. Die oben zitierten guten Ergebnisse bezüglich Jc wurden mittels des so genannten TFA-Systems (TFA = Trifluoracetat) erzielt (s.z.B. D12). Bei diesem Beschichtungssystem werden alle Metalle als Acetate in Trifluoressigsäure gelöst, so dass formal vollständig Metall-Trifluoracetate entstehen, die bei der Auftrocknung der Beschichtungslösung nach dem Verdampfen von Essigsäureresten und Trifluoressigsäure auf dem Substratband verbleiben. TFA-Lösungen werden vor allem deshalb verwendet, weil bei der Verwendung anderer vor allem organischer Metallsalze beim Abtrocknen bzw. bei der Pyrolyse der Beschichtung Barium-Carbonat entsteht. Barium-Carbonat ist so stabil, dass es bei den nachfolgenden Prozessbedingungen nicht mehr zerstört werden kann, und Barium somit nicht für die Bildung des YBCO-Supraleiters zur Verfügung steht und an Korngrenzen den Stromtransport behindert. Durch die Bildung von Bariumfluorid nach dem ersten Pyrolyseschritt wird die Bildung von Bariumcarbonat bei der TFA-Route effektiv verhindert. Die Bildung von Bariumfluorid setzt aber auch voraus, dass der Glühatmosphäre zur abschließenden Kristallisation des Supraleiters Wasserdampf zugesetzt werden muss. Der Wasserdampf muss die abgeschiedene Precursorschicht von der Oberfläche her durchdringen, um mit Bariumfluorid zu BariumOxid und Flusssäure zu reagieren. Die Flusssäure muss die Schicht wiederum verlassen. Die benötigten langen Diffusionswege für relativ große Moleküle bewirken einerseits eine -Porenbildung in der Supraleiterschicht und verhindern andererseits das Aufwachsen dicker supraleitender Schichten, da mit zunehmender Schichtdicke die Diffusionsmöglichkeiten begrenzt werden. Dieser Nachteil kann teilweise durch eine Mehrfachbeschichtung umgangen werden. Dieser Weg führt aber zu immer geringeren Schichtdickezuwächsen und schlechterer Textur bei steigender Anzahl von Beschichtungszyklen [D6-D10].

Neben der Diffusionsproblematik ist die Verwendung von fluorierten Precursoren in der Beschichtungslösung aufgrund der Giftigkeit der entstehenden Flusssäure in technischen Prozessen problematisch. Flusssäure bzw. Fluorwasserstoff sind bereits in geringsten Konzentrationen als sehr giftig eingestuft. In technischen Anlagen muss eine Vielfalt von Überwachungsmaßnahmen ergriffen werden, um eine Exposition von Mitarbeitern und eine Emission in die Umwelt zu verhindern. Zudem sollte die Menge an verwendeter Trifluoressigsäure aufgrund ihrer ökotoxischen Wirkung sowie biologischer Effekte (Schädigende Wirkung auf Wasserorganismen, kann in Gewässern längerfristig schädliche Wirkungen haben, schädigende Wirkung durch pH-Verschiebung, auch in Verdünnung noch ätzend, Gefahr für Trinkwasser) gering gehalten werden. Es ist daher sowohl aus Gründen des Arbeits- und Umweltschutzes als auch aus Gründen der Prozessökonomie wünschenswert, den Fluorgehalt der Beschichtungslösung so weit wie möglich zu senken, bzw. ganz auf fluorhaltige Precursoren zu verzichten.

Bisher konnte noch kein fluorfreies Beschichtungsverfahren für die supraleitende Schicht entwickelt werden, mit welchem YBCO-Schichten hergestellt wurden, die auch nur annähernd, die supraleitenden Eigenschaften aufweisen wie Schichten, welche mittels der TFA Methode hergestellt wurden. Offensichtlich ist die Verwendung fluorfreier Systeme aufgrund der oben beschriebenen Problematik der Bariumcarbonatbildung nicht möglich. Folgerichtig wird intensiv daran gearbeitet den Fluorgehalt der Beschichtungssysteme zu erniedrigen. Dies erfolgt z.B. durch Verwendung einer Mischung aus Trifluoressigsäure und Essigsäure als Lösungsmittel, damit nicht wie bei einem reinen TFA-Prozess alle Metallionen formal vollständig als Trifluoracetat vorliegen sondern nur noch z.B. die Bariumionen. Die anderen Ionen, d.h: Kupfer und Yttrium, liegen bei diesen Systemen nach dem Auf trocknen der Beschichtungslösung als Acetate bzw. Oxide vor. Die im Fluoranteil reduzierten Beschichtungssysteme verringern die Freisetzung von Flusssäure bzw. Fluorwasserstoff und damit den umwelttechnischen Aufwand im Prozess. Da aber die Diffusionswege durch die gesamte Schichtdicke weiterhin sehr lang sind, konnten mit diesen Systemen keine nennenswerten Verbesserungen der Textur bzw. Stromdichte dickerer Supraleiterschichten erzielt werden.

### Aufgabenstellung

Die der Erfindung zugrundeliegenden Aufgabenstellung ist es, ein Verfahren zur Herstellung eines bandförmigen HTSL zu schaffen, bei dem die Schichtdicke der supraleitenden Schicht größer als 500nm ist und bei dem J_{c} im wesentlichen unabhängig von der Schichtdicke ist.

### Darstellung der Erfindung

Ausgangspunkt der Lösung der Aufgabe war die Überlegung, die Diffusionswege für die Flusssäure bzw, den Fluorwasserstoff bei der Umwandlung der Precursoren (hier Bariumfluorid) in den Supraleiter bei der Glühbehandlung entscheidend zu verringern, da dieser wie oben beschrieben limitierend auf die Bildung qualitativ hochwertiger Supraleiterschichten wirkt. Die Aufgabe wurde gemäß Anspruch 1 der vorliegenden Erfindung durch eine Mehrfachbeschichtung mit unterschiedlichen Beschichtungssystemen gelöst. Während konventionell mehrfach mit ein und derselben Beschichtungslösung, die ggf. fluorreduziert sein kann, beschichtet wird, wird erfindungsgemäß zunächst in einem ersten Schritt mit einer stark reduzierten oder vollständig fluorfreien Beschichtungslösung beschichtet und anschließend mit einer fluorhaltigen Beschichtungslösung, ggf. weitere nachfolgende Beschichtungen erfolgen ggf. mit Beschichtungslösungen mit steigendem Fluorgehalt gegenüber der vorhergehenden. Durch dieses Vorgehen wird eine zweilagige oder mehrlagige Architektur in der Precursorschicht erzeugt. Die fluorhaltige Teilschicht mit dem höchsten Fluorgehalt befindet sich direkt an der Oberfläche, so dass die Diffusionswege bei erfindungsgemäßem Schichtaufbau deutlich geringer sind als bei einer herkömmlichem Aufbau aus einer homogenen Precursorschicht. Die Teilschichten aus fluorfreier bzw. fluorreduzierter und fluorhaltiger Beschichtung werden dabei in mehreren Zyklen aufgebracht.

Die erfindungsgemäße Architektur ermöglicht es, den Gesamtfluorgehalt der Precursorschicht drastisch zu senken, da die fluorhaltige Deckschicht / Teilschicht im Vergleich zur fluorfreien oder fluorreduzierten Teilschicht dünn gehalten werden kann. Dadurch wird die Emission von Flusssäure bzw. Fluorwasserstoff maßgeblich gesenkt und die Verfahrenstechnik vereinfacht.

Im Gegensatz zu den bisher bekannten Untersuchungen zeigt sich bei der erfindungsgemäßen Architektur, dass die dünne fluorhaltige Teilschicht ausreicht, um die Bariumcarbonatproblematik in der fluorfreien Teilschicht wirksam zu unterdrücken. Dies lässt sich durch Beugungsdiagramme nachweisen, die einen durchgängig hohen Texturgrad der supraleitenden Schicht zeigen und keinen Hinweis auf das Vorhandensein von Bariumcarbonat liefern. Der hohe Texturgrad kann nur bei vollständiger Umsetzung der einzelnen Metallprecursoren zum Supraleiter erzielt werden. Anwesendes Bariumcarbonat würde die Textur dagegen maßgeblich stören.

Vergleiche mit konventionellen Beschichtungssystemen zeigen einen weiteren gewünschten Effekt der erfindungsgemäßen Beschichtung. Bei gleicher Anzahl von Beschichtungszyklen zeigt sich, dass mittels einer erfindungsgemäßen Schichtarchitektur Schichtdicken erreicht werden, die um ein Mehrfaches über denen konventioneller Beschichtungen liegen- Die gemessene Textur über die Gesamtschicht zeigt dabei keine signifikante Variation, was eine gleichbleibend hohe Textur und damit für eine gleichbleibend hohe Stromdichte in der dicken supraleitenden Schicht bedeutet.

Die Herstellung von texturierten REBCO-Schichten (RE steht für Rare Earth und bezeichnet Elemente der Gruppe der seltenen Erden, also Y, Ce, Gd, etc.) hoher Stromtragfähigkeit mit Schichtdicken > 500 nm erfolgt durch Aufbringen einer fluorfreien REBCO-Precursor-Zwischenschicht, Pyrolyse dieser fluorfreien Schicht, gefolgt von anschließender Beschichtung mit einer TFA-Lösung. Die Pyrolyse der TFA-Schicht erfolgt bei Temperaturen bis 400°C in feuchter Atmosphäre N₂ / 2,5% O₂. Anschließend wird die gemeinsame REBCO-Phasenbildung bei Maximaltemperaturen von 780-790°C in feuchter N₂ /100 ppm O₂ Atmosphäre durchgeführt. Geringe Erhöhung des Cu-Gehalts in der TFA-Precursor-Lösung kann zur Erhöhung von T_{c} und J_{c} führen. Dies geschieht durch die Erhöhung des Schmelzanteils während der Reaktion, durch Agieren der CuO-Ausscheidungen als Sauerstoffquelle, durch das Vorhandensein schneller Diffusionspfade für Sauerstoff sowie durch die Eigenschaft der Ausscheidungen, als pinning-Zentren zu wirken [D11].

Zur Herstellung der Beschichtungslösungen kann es dabei vorteilhaft sein, diese zu erwärmen oder unter Rühren so zu erhitzen, dass diese im Rückfluss sieden. Des Weiteren können der Beschichtungslösung verschiedene Additive beigemischt werden, um den Beschichtungsprozess positiv zu beeinflussen und die Lösungsstabilität zu erhöhen. Zur Prozessverbesserung werden einerseits Benetzungsmittel, d.h. Mittel, welche die Oberflächen-. spannung der Beschichtungslösung herabsetzen und so eine gleichmäßige Beschichtung über die Fläche und an Kanten ermöglichen, und andererseits Geliermittel, die die gleichmäßige Auftrocknung der Beschichtung ohne Abplatzungen, Risse und Poren ermöglichen, verwendet. Zur Stabilisierung der Lösungen können u.a. Antioxidantien eingesetzt werden.

Die Beschichtung des Substrates mit erfindungsgemäßen Beschichtungslösungen kann auf verschiedene Arten erfolgen. Die Lösungen können durch dip-coating (Tauchen des Substrates in die Lösung), spin-coating (Aufbringen der Lösung auf ein rotierendes Substrat), spray-coating (Aufsprühen bzw. Aufzerstäuben der Lösung auf das Substrat), capillary-coating (Abringen der Lösung über eine Kapillare), ink-jet-printing (Tintenstahldrucken) und ähnliche Techniken aufgebracht werden. Beim Aufbringen einer Lösung können optional entweder durch gezieltes Schützen von Bereichen, z.B. mittels Photolack und Entfernung nach der Beschichtung, oder durch das Verfahren selbst, z.B. bei Druckverfahren wie dem Ink-Jet-Printing, Strukturen in der Supraleiterschicht erzeugt werden.

Die Beschichtung und Trocknung kann generell sowohl im Batchverfahren als auch kontinuierlich erfolgen. Bevorzugt sind hier, aufgrund des geringeren Handhabungsaufwandes, kontinuierliche Anlagen. Diese Anlagen bestehen aus einem Abwickler mit aktiver oder passiver Bremse, um das Substratband in der Anlage unter Spannung zu halten. Dies kann z.B. durch einen so genannten Tänzer (doppelte Umlenkrollen mit definierter Zugkraft) erreicht werden. Das Substratband wird anschließend durch die Beschichtungseinheit geführt, die z.B. aus einem Tauchbad bestehen kann. Durch variable Anordnungen der Führrollen können verschiedene Auszugswinkel des Substratbandes aus der Beschichtungslösung im Bad erreicht werden. Das Bad kann zusätzlich zur Erhöhung der Löslichkeit einzelner Komponenten im Lösungsmittel beheizt werden. Die Beschichtungseinheit kann erfindungsgemäß auch nach einem der weiteren, oben genannten Verfahren (außer spin-coating) betrieben werden. Nach der Beschichtungseinheit erfolgt das Auftrocknen der Beschichtung in einer Trockenstrekke. Diese Strecke kann sowohl bei einer Temperatur als auch mit mehreren Temperaturen und Temperaturverläufen betrieben werden. Vorteilhaft ist eine mindestens zweistufige Trocknung mit einer niedrigen Temperatur T1, die wenig unterhalb der Siedetemperatur des verwendeten Lösungsmittels liegt, und einer Temperatur T2, die oberhalb der Siedetemperatur liegt. Durch dieses Verfahren wird ein besonders homogenes und damit riss- und porenfreies Auftrocknen erreicht. Nach dem Auftrocknen wird das Band über einen Aufspuler wieder aufgewickelt. Vorteilhaft für die anschließende Glühbehandlung ist es, das Band auf ein Trägerrohr in Form einer Flachspule (Solenoid) aufzuwickeln. Dies geschieht durch eine gleichzeitige Dreh- und Linearbewegung des Aufspulers. Träger für das Band ist beispielsweise ein wärmefestes Keramikrohr oder ein beschichtetes Metallrohr. Die verschiedenen Einheiten, insbesondere die Beschichtungseinheit und die Trocknungseinheit sind vorteilhaft so gestaltet, dass der Prozess unter einer definierten Atmosphäre stattfinden kann. In den verschiedenen Einheiten kann es vorteilhaft sein, unterschiedliche Atmosphären einzustellen. Ein hoher Dampfdruck des Lösungsmittels in der Beschichtungseinheit kann z.B. vorteilhaft sein, um ein übermäßiges Verdampfen des Lösungsmittels aus dem Beschichtungsbad und damit ein Aufkonzentrieren der Beschichtungslösung zu vermeiden.

Voraussetzung für die notwendig gute Texturierung der supraleitenden Schicht ist eine gute texturübertragende Eigenschaft des Puffers. Daher kommt vorzugsweise ein mittels CSD aufgebrachter Puffer mit verbesserter texturübertragender Eigenschaft zum Einsatz. Ein solches Verfahren wird in der DE 10 2004 038 030 beschrieben. Hierbei wird mittels der Kombination von polaren Lösungsmitteln und Metalloxiden eine auch in den obersten Schichtbereichen gut texturierte Pufferschicht erzeugt.

Zum Schutz des Supraleiters und als alternativer Stromweg bei Ausfall der Supraleiterschicht kann eine Metallschicht als Funktionsschicht aufgebracht werden, z.B. mittels galvanischer Methoden oder durch Aufdampfen.

### Beispiele

Folgende Beispiele seien angeführt, ohne sich auf diese zu beschränken:

### (1) Beispiel 1

Y(III)-Acetat-Tetrahydrat (Y(OOCCH3)·4H2O: Alfa Aesar, 99,99 % (REO), kristallin) und Cu(II)-Acetat-Monohydrat (Cu(OOCCH3)2·H2O: Aldrich, ≥ 99,99 %, kristallin) werden in Wasser gelöst. Nach Zugabe von Ethanol (CH3CH2OH: Merck, zur Synthese, ≥ 99 %, Schmelzpunkt: -114,5°C, Siedepunkt: 78,3°C, Flammpunkt: 12°C) und Pivalinsäure (Trimethylessigsäure: (CH3)3CCOOH: Merck, zur Synthese, > 98 %, Schmelzpunkt: 32-35°C, Siedepunkt: 164°C, Flammpunkt: 64°C, Löslichkeit in H2O: 25g/l (25°C)) wird die erhaltene Lösung im Trockenschrank getrocknet. Das entstehende Gemenge aus Y(III)- und Cu(II)-trimethylacetat, wird mit Bariumhydroxid-Octahydrat (Ba(OH)2·8 H2O: Merck, zur Analyse, ≥ 98 %, Schmelzpunkt: 78°C) vermengt. Durch Zusatz von Propionsäure (Methylessigsäure, CH3CH2COOH: Merck, zur Synthese, ≥ 99%, Schmelzpunkt: -21°C, Siedepunkt: 141°C, Flammpunkt: 50°C), Propylamin (1-Aminopropan, CH3CH2CH2NH2: Merck, zur Synthese, > 99 %, Schmelzpunkt: -83°C, Siedepunkt: 48-50°C, Flammpunkt: -30°C), Methanol (CH3OH: Merck, zur Analyse, ACS, ISO, ≥ 99,8%, Schmelzpunkt: -98°C, Siedepunkt: 64,5°C, Flammpunkt: 11°C) und Toluol (Methylbenzol, C6H5CH3: Merck, für die Spektroskopie, ≥ 99,9 %, Schmelzpunkt: -95°C, Siedepunkt: 110,6°C, Flammpunkt: 4°C) wird eine 0,2 molare kolloidale Lösung hergestellt, Lösungen geringerer Konzentration bedingen dabei eine dünnere Schicht mit ansonsten vergleichbaren Werten, Lösungen höherer Konzentration (oberhalb von 0,35 molar) bedingen zu dicke Schichten, welche zur Rissbildung und damit schlechteren Eigenschaften neigen. Strontiumtitanat-Substrate (Orientierung (100)) sowie mit Pufferschichten versehenes Metallband aus einer Legierung Ni - 5 at-% W wurden mit Hilfe des Dip-Coating Verfahrens beschichtet. Die Verweilzeit in der Lösung betrug 15 s. Die Proben wurden mit einer Ziehgeschwindigkeit von 0,1 cm/s aus der Lösung herausgezogen. Die Ziehgeschwindigkeit kann dabei in einem weiten Bereich von 0,04 bis 0,5 cm/s variieren, wobei eine niedrigere Ziehgeschwindigkeit eine geringere Schichtdicke und eine höhere Zehgeschwindigkeit eine größere Schichtdicke bewirkt. Das Trocknen der Schicht erfolgte bei Temperaturen bis maximal 200°C im Trockenschrank. Die anschließende Pyrolyse wurde bei T ≤ 600°C in einem Kammerofen unter Luft durchgeführt. Die Substrate mit der ersten pyrolysierten Schicht wurden anschließend zweimal in YBCO-TFA-Precursorlösungen unterschiedlicher Zusammensetzungen (0,25 molar bezüglich Y) mit Verweilzeiten von 30 und 15 s und einer Ziehgeschwindigkeit von 0,1 cm/s getaucht. Die YBCO-TFA-Precursorlösungen wurden aus Y(III)-acetat-Tetrahydrat (Y(OOCCH3)3·4 H2O: Alfa Aesar, 99,99% (REO), kristallin), Ba(II)-acetat (Ba(OOCCH3)2: Alfa Aesar, 99,999% (metals basis)) und Cu(II)-acetat-Monohydrat (Cu(OOCCH3)2·H2O: Aldrich, ≥ 99,99%, kristallin) unter Verwendung von Trifluoressigsäure (CF3COOH: Merck, zur Synthese, > 99 %, Schmelzpunkt : -15°C, Siedepunkt: 72°C, umweltgefährlich!) und Methanol (CH3OH: Merck, zur Analyse, > 99,8 %, Schmelzpunkt: -98°C, Siedepunkt: 64,5°C, Flammpunkt: 11°C, giftig!) als Lösungsmittel hergestellt. Die Zusammensetzungen der Lösungen wurden wie folgt eingestellt:

### Precursorlösung 1:

Y:Ba:Cu = 1: 2: 3, 0;25 molare Lösung bezüglich Y. Die Lösung wurde mit einem Überschuss von 15% Trifluoressigsäure im Vergleich zur Standardzusammensetzung (Stand der Technik) hergestellt.

### Presursorlösung 2 :

### Y:Ba:Cu = 1 : 2 : 3,2-3,8

Die erhaltenen Schichten wurden in feuchter Atmosphäre wärmebehandelt. Die Pyrolyse erfolgte bei T ≤ 400°C in N₂ / 2,5% O₂ - Atmosphäre. Die YBCO-Phasenbildung wurde unter einer Atmosphäre von N₂ / 100 ppm O₂ bei Maximaltemperaturen von 780 bis 790°C und mit einer Haltezeit zwischen einer halben und einer Stunde durchgeführt. Die Maximaltemperatur liegt immer unterhalb der Schmelztemperatur des YBCO. Die Schmelztemperatur wiederum ist von der Sauerstoffkonzentration der Ofenatmosphäre abhängig. Bei höheren Sauerstoffgehalten bis zu 1% ist die Schmelztemperatur um ca. 10° erhöht, bei sauerstofffreier Atmosphäre um ca. 5° erniedrigt. Die Abkühlung der Proben erfolgte in O₂ Atmosphäre mit einer Haltezeit von 2 Stunden bei einer Temperatur zwischen 500 und 400°C. Typische Ergebnisse sind:
**Probe YBZ 289 (STO-Substrat, Tₘₐₓ = 785°C, Precursor-Lösung 1, Ziehgeschwindigkeit 0,1 cm/s):**
T_{c50} = 89,8 K, ΔT_{c} = 1 K, J_{c} (resistiv) - 1,15 MA/cm²
FWHM(ϕ-scan) = 2,50 ± 0,03°, FWHM(ω-scan) = 0,90 ± 0,01° Schichtdicke: ≈610 nm
**Probe YBZ 291 (STO-Substrat, Tₘₐₓ = 785°C, Precursor-Lösung 2 (1 : 2 : 3,4, Ziehgeschwindigkeit 0,1 cm/s):**
T_{c50} = 89,6 K, ΔT_{c} = 0,8 K, J_{c} (resistiv) - 0,85 MA/cm²
FWHM (ϕ-scan) - 2,11° , fWHM (ω-scan) - 0,95°
Schichtdicke: ≈ 560 nm

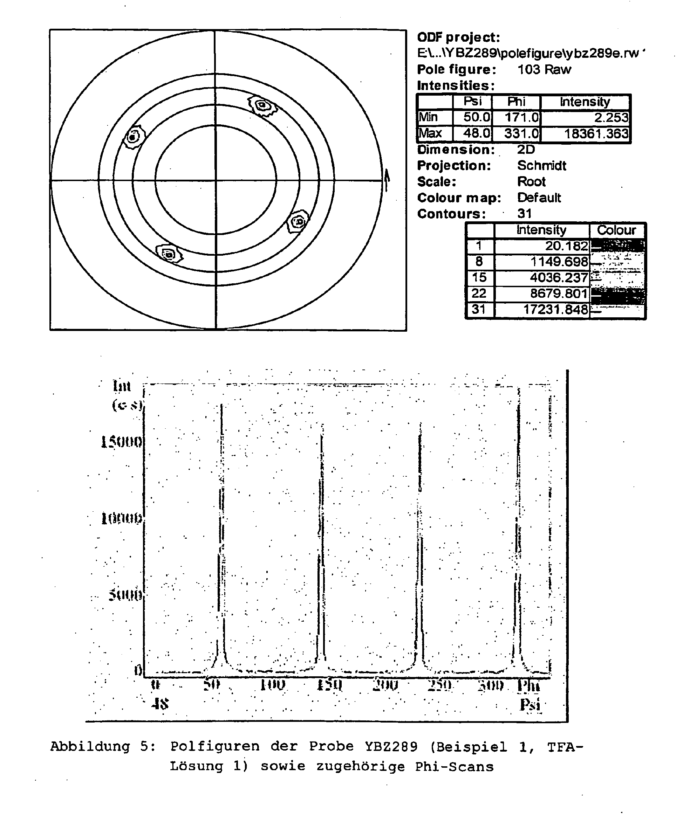

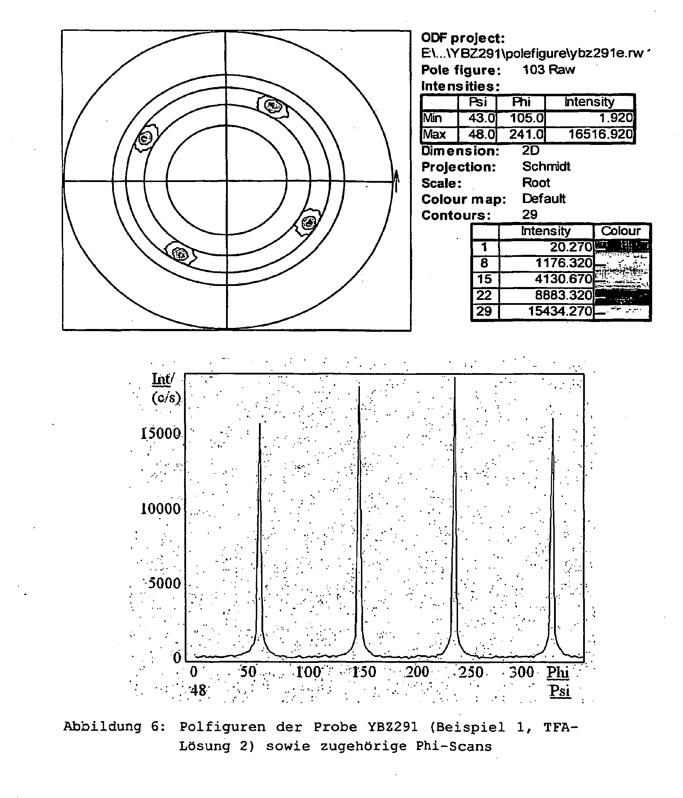

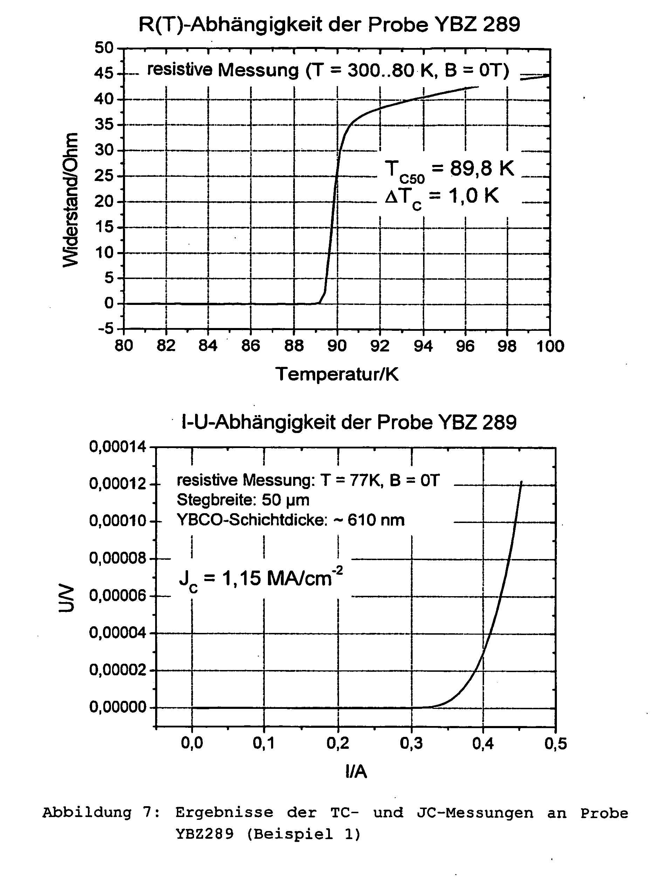

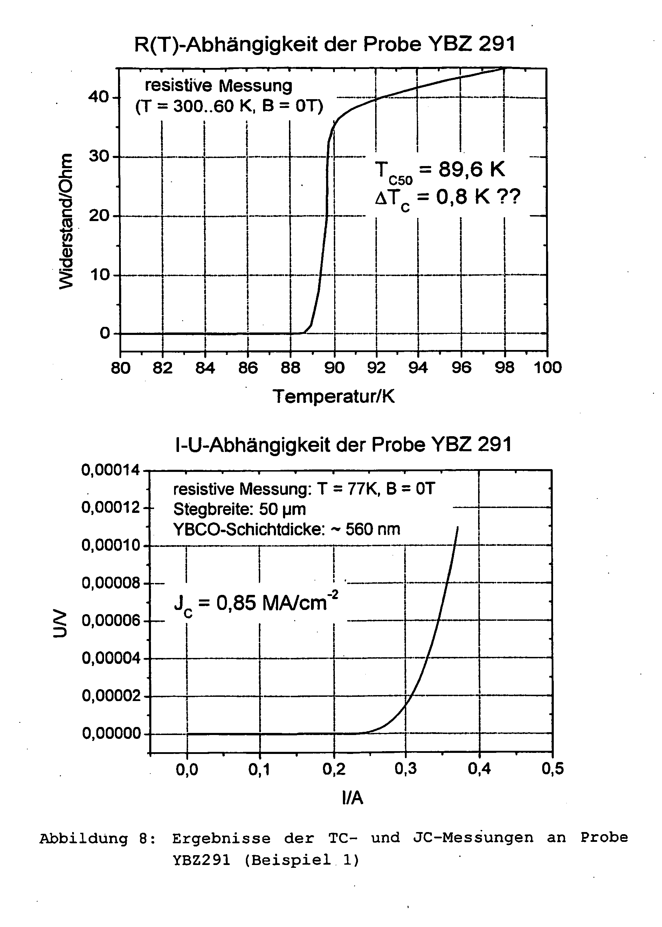

Ergebnisse der Polfigur-Messungen sowie von Phi-Scans sind Abbildung 5 und 6, die Ergebnisse der T_{c}- und J_{c}-Messungen Abbildung 7 und 8 zu entnehmen.

Vergleichbare Ergebnisse lassen sich auch erzielen, wenn man anstelle von Y(III)-Acetat-Tetrahydrat als Ausgangsstoff Ho(III)-Acetat-Tetrahydrat verwendet.

### (2) Beispiel 2

In einem weiteren Versuch wurden die Reaktionsbedingungen variiert. Die eingesetzte fluorfreie Precursor-Lösung wurde wie in Beispiel 1 angegeben hergestellt. Die Lösung wies im Gegensatz zu Beispiel 1 jedoch eine erhöhte Viskosität auf. Als TFA-Precursor-Lösung wurde die oben angegebene Lösung 1 verwendet. Ein Strontiumtitanat-Substrat (Orientierung (100)) wurde mit Hilfe des Dip-Coating Verfahrens beschichtet. Für die fluorfreie YBCO-Precursorlösung wurden die gleichen Beschichtungs-, Trocknungs- und Pyrolysebedingungen wie in Beispiel 1 gewählt. Anschließend erfolgte ein zweimaliges Tauchen in der TFA-Precursorlösung mit einer Verweilzeit von 30 bzw. 15 Sekunden sowie einer Ziehgeschwindigkeit von 0,2 cm/s. Die Verweilzeit hat, solange ein Minimalwert nicht unterschritten wird, keinen Einfluss auf das Ergebnis. Abhängig vom Benetzungsverhalten der Lösung liegt der Minimalwert bei 2 bis 5 Sekunden. Das Trocknen der Schicht, die anschließende Pyrolyse sowie die Kristallisation erfolgten unter oben angegebenen Bedingungen. Mit diesem Verfahren konnten Schichten mit, im Vergleich zu Beispiel 1, erhöhter Schichtdicke erzeugt werden.
**Probe (STO-Substrat, fluorfreie YBCO-Precursorlösung geringfügig höherer Viskosität, Tₘₐₓ = 785°C, Precursor-Lösung 1 (1 : 2 : 3), Ziehgeschwindigkeit 0,2 cm/s):**
Schichtdicke: ≈ 880 nm

### (3) Beispiel 3

Auf ein texturiertes Metallband (Ni - 5 at-% W) gemäß D3-D5 wurde zunächst ein Pufferschichtsystem aufgebracht. Bei dem Metallband handelt es sich um eine Reinnickelband. Durch Einlegieren von Wolfram bis zu einem Anteil von 8% kann die Zugfestigkeit des Bandes ohne Einfluss auf das Ergebnis der Beschichtung in diesem Beispiel erhöht werden. Auch andere Legierungen wie z.B. Ni-0,1%Mn können ohne Einfluss auf das Endergebnis dieses Beispiels verwendet werden.

Basis der Beschichtungslösung für eine erste Pufferschicht sind Lanthan(III)- und Zirkonium(IV)-(2,4)pentandionat (Acetylacetonat) (Lanthan(III)-(2,4)pentandionat, La[CH₃COCHCOCH₃]₃ ·x H₂O: Alfa Aesar, 99,9% (REO) Pulver, Schmelzpunkt: 143°C; Zirkonium(IV)-(2,4) pentandionat, Zr [CH₃COCHCOCH₃]₄: Strem Chemicals, ≥98%, kristallin). Die Lösung wurde gemäß der Pufferstöchiometrie auf eine Konzentration von 0,1 M bezogen auf La₂Zr₂O₇ eingestellt. Zur genauen Einstellung der Metallgehalte wurden die Ausgangsstoffe mittels ICP-OES (Inductively coupled plasma optical emission) charakterisiert. Als Lösungsmittel für die Lösung wurde Propionsäure (Propionsäure, CH₃CH₂COOH: Merck, ≥99%, Schmelzpunkt: -21°C, Siedepunkt: 141°C, Flammpunkt: 50°C) verwendet.

Die Beschichtung erfolgte an Substratbändern mit einem Querschnitt von 5 x 0,1 mm² und einer Länge von 50 m in einer kontinuierlichen Beschichtungsapparatur.

Diese Apparatur besteht aus einer Abspul-, einer Beschichtungs-, einer Trocknungs- und einer Aufwickeleinheit. Eine schematische Zeichnung zeigt Abbildung 3. Das Band wird unter einem Zug von 10N mit einer Geschwindigkeit von 5cm/min durch die Anlage gezogen. Die Zugkraft wird dabei so gewählt, dass sie geringer ist als die Streckgrenze des verwendeten Metallbandes. Die Beschichtung erfolgt mit einem Auszugswinkel von 70° bezogen auf die Lösungsoberfläche. Der Auszugswinkel kann in einem Bereich von 20 - 90° variiert werden, wobei ein geringerer Winkel eine größere Schichtdicke bedeutet. Gleiche Schichtdicken können z.B. mit der Kombination 70° und 5cm/min sowie 90° und 5,8cm/min erreicht werden. Die Trocknung erfolgt in zwei Schritten. Die Vortrocknung erfolgt unterhalb der Siedetemperatur des Lösungsmittels (Methanol; 65°C) bei Temperaturen von 60°C auf einer Strecke von 50cm die Endtrocknung auf einer Strecke von 100cm bei einer Temperatur von 90°C. Das Band wird nach der Trocknung auf ein Keramikrohr (Korund) mit dem Durchmesser von 20 cm und einer Länge von 100 cm in Form einer Spirale (Solenoid) aufgewickelt.

Das Band wird mit dem Trägerrohr in einen Glühofen überführt und bei einer Temperatur von 900°C innerhalb von 2h kristallisiert.

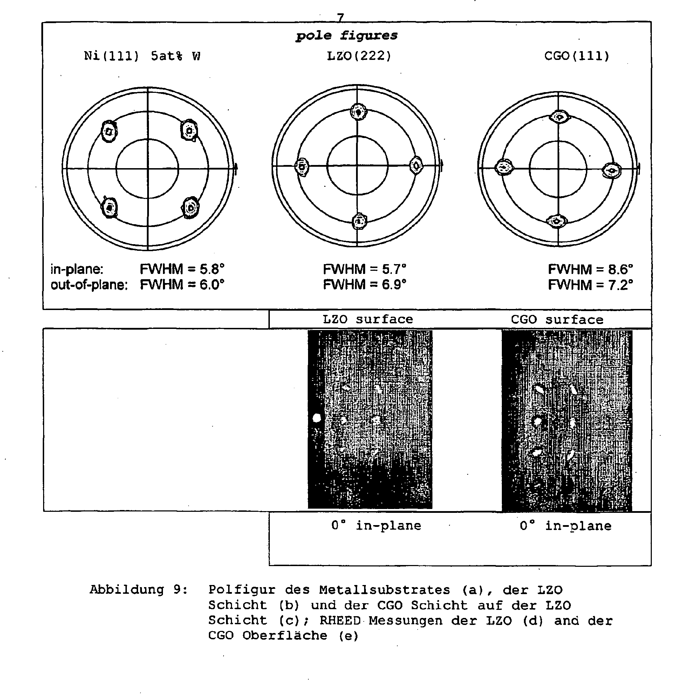

Als zweite Pufferschicht wurde Ceroxid aufgebracht. Die Beschichtungslösung besteht hier aus Ce(III)-acetat gelöst in Propionsäure, 2-Propanol und Acetylaceton (Ce(III)-acetat, Ce(CH₃COO)₃·xH₂O; Sigma-Aldrich Chemie, 99,9% und Propionsäure, CH₃CH₂COOH: Merck, ≥99%, Schmelzpunkt: -21°C, Siedepunkt: 141°C, Flammpunkt: 50°C und 2-Propanol (Isopropanol), (CH₃)₂CHOH; Sigma-Aldrich Chemie, 99,5%, Siedepunklt 82°C und Acetylaceton, CH₃COCH₂COCH₃; Sigma-Aldrich Chemie, >99%, Siedepunkt 140°C. Die Lösungsmittel hatten das Verhältnis 5:2:1, wobei in einem weiten Bereich mit Anteil Propionsäure > 50% variiert werden kann. Die Lösungskonzentration wurde auf 0,25M eingestellt. Die Beschichtungslösung wurde analog zu ersten Beschichtungslösung aufgebracht. Die Kristallisation erfolgte bei Temperaturen von 950°C innerhalb einer Stunde. Polfiguren und RHEED Messungen (s. Abbildung 9) zeigen eine hervoragende Texturierung der Pufferschicht.

Nach Austausch der Puffer-Beschichtungslösung in der kontinuierlichen Beschichtungsanlage gegen eine fluorfreie YBCO-Beschichtungslösung gemäß Beispiel 1 wird das erhaltene Band mit einer Geschwindigkeit von 6 cm/min unter ansonsten unveränderten Bedingungen durch die Anlage geführt und wiederum auf ein Keramikträgerrohr aufgespult. Die aufgetragene Schicht wurde anschließend auf dem Keramikträgerrohr bei 600°C unter Luft pyrolysiert. Die Temperatur muss dabei mindestens 550°C betragen. Nach erneutem Austausch der Beschichtungslösung gegen eine fluorhaltige Lösung gemäß Beispiel 1 erfolgte wiederum ein Durchlauf durch die Anlage mit einer Geschwindigkeit von 0,2 cm/s.

Das Band mit den erhaltenen Schichten wurde auf dem Keramikträgerrohr in feuchter Atmosphäre wärmebehandelt. Die Pyrolyse erfolgte bei T ≤ 400°C in N₂ / 2,5% O₂ - Atmosphäre. Die Kristallisation wurde unter einer Atmosphäre von N₂ / 100 ppm O₂ bei Maximaltemperaturen von 780 bis 790°C und mit einer Haltezeit zwischen einer halben und einer Stunde durchgeführt. Die Maximaltemperatur liegt dabei immer unterhalb der Schmelztemperatur des YBCO. Die Schmelztemperatur wiederum ist von der Sauerstoffkonzentration der Ofenatmosphäre abhängig. Bei höheren Sauerstoffgehalten bis zu 1% ist die Schmelztemperatur um ca. 10° erhöht, bei sauerstofffreier Atmosphäre um ca. 5° erniedrigt. Die Abkühlung der Proben erfolgte in O₂ Atmosphäre mit einer Haltezeit von 2 Stunden bei einer Temperatur zwischen 500 und 400°C. Typische Ergebnisse sind:

Polfigur-Messungen, Phi-Scans sowie T_{c}- und J_{c}-Messungen an ausgewählten Kurzproben ergaben Messergebnisse, die denen der Messungen an den erfindungsgemäß hergestellten Proben aus Beispiel 1 entsprechen.

## Patentansprüche

1. Verfahren zur Herstellung eines bandförmigen Hochtemperatur-Supraleiters (HTSL) aus einem Substrat auf dem eine Pufferschicht ist, auf die mindestens zwei HTSL-Precursor-Schichten aufgebracht werden, mit den Schritten:
a) Herstellen einer HTSL-Precursorlösung,
b) Aufbringen der HTSL-Precursorlösung,
c) Trocknen,
d) Pyrolyse,
e) Wärmebehandlung zur Erzeugung einer supraleitenden Schicht,
wobei die Schritte a) bis d) mindestens einmal wiederholt werden, und die Konzentration von Fluorbestandteilen in der HTSL-Precursorlösung von Schicht zu Schicht erhöht wird, d.h. zunächst fluorarme und später fluorreiche Precursorlösungen verwendet werden.

2. Verfahren nach-Anspruch 1, **dadurch gekennzeichnet, dass** als erste eine fluorfreie HTSL-Precursorlösung aufgebracht wird.

3. Verfahren nach einem der Ansprüche 1 oder 2, **dadurch gekennzeichnet, dass** als Lösungsmittel für mindestens eine HTSL-Precursorlösung Propionsäure und/oder Pivalinsäure und/oder Methanol und/oder Toluol verwendet werden.

4. Verfahren nach einem der Ansprüche 1 bis 3, **dadurch gekennzeichnet, daß** die Wärmebehandlung in Schritt 1e) bei Temperaturen unterhalb der Schmelztemperatur des HTSL erfolgt.

5. Verfahren nach einem der Ansprüche 1 bis 4, **dadurch gekennzeichnet, dass** zur Herstellung mindestens einer HTSL-Precursorlösung Y(III)- und/oder Ho(III)- Cu(II)-Trimethylacetat und/oder Bariumhydroxid-Octahydrat verwendet wird.

6. Verfahren nach Anspruch 5, **dadurch gekennzeichnet, dass** mindestens eine etwa 0,1 bis 0,5 molare HTSL-Precursorlösung, bezogen auf die Seltenerdemetalle, verwendet wird.

7. Verfahren nach einem der Ansprüche 1 bis 6, **dadurch gekennzeichnet, dass** zur Herstellung mindestens einer HTSL-Precursorlösung Trifluoressigsäure verwendet wird.

8. Verfahren nach einem der Ansprüche 1 bis 7, **dadurch gekennzeichnet, dass** mindestens eine Trifluoracetat enthaltende HTSL-Precursorlösung verwendet wird.

9. Verfahren nach einem der Ansprüche 5 bis 8, **dadurch gekennzeichnet, dass** mindestens eine fluorarme HTSL-Precursorlösung verwendet wird, deren Fluorgehalt nicht zur vollständigen Absättigung der Ba-Ionen genügt, wobei diese HTSL-Precursorlösung vorzugsweise weniger als 6 Mol Fluor pro Mol YBCO enthält.

10. Verfahren nach einem der Ansprüche 5 bis 9, **dadurch gekennzeichnet, dass** mindestens eine fluorreiche HTSL-Precursorlösung, deren Fluorgehalt mindestens 30 Mol Fluor pro Mol YBCO beträgt, verwendet wird.

11. Verfahren nach einem der Ansprüche 1 bis 10, **dadurch gekennzeichnet, dass** vor Schritt 1a) mindestens eine weitere Pufferschicht auf das Substrat aufgebracht wird.

12. Verfahren nach Anspruch 11, **dadurch gekennzeichnet, dass** die Pufferschicht, bei mehr als einer Pufferschicht die letzte Pufferschicht, mindestens an ihrer Grenzfläche zu der HTSL-Schicht weitgehend texturiert ist.

13. Verfahren nach einem der Ansprüche 1 bis 11, **dadurch gekennzeichnet, dass** die Pufferschicht, bei mehr als einer Pufferschicht zumindest eine Pufferschicht, vor Schritt 1a) durch
a) Herstellen einer Beschichtungslösung enthaltend ein polares Lösungsmittel mit mindestens einer freien Hydroxylgruppe,
b) Aufbringen der Beschichtungslösung auf das Metallsubstrat,
c) Trocknen, und
d) Erzeugen der Pufferschicht durch Glühbehandlung, aufgebracht wird.

14. Verfahren nach Anspruch 13, **dadurch gekennzeichnet, dass** mindestens eine Pufferschicht erzeugt wird, die aus Zirkonaten, vorzugsweise La₂Zr₂O₇, und/oder Seltenerdoxiden, vorzugsweise CeO₂/Gd₂O₃ und/oder Y₂O₃ ist, und dass die Pufferschicht eine Texturierung hat, die bei einer RHEED Messung vor Aufbringung einer HTSL-Schicht zu diskreten Reflexen und nicht ausschließlich zu Beugungsringen führt.

15. Verfahren nach Anspruch 13 oder 14, **dadurch gekennzeichnet, dass** als polares Lösungsmittel mit mindestens einer freien Hydroxylgruppe eine Carbonsäure, bevorzugt Propionsäure, verwendet wird.

16. Verfahren nach einem der Ansprüche 13 bis 15, **dadurch gekennzeichnet, dass** vor dem Aufbringen einer HTSL-Schicht auf die Pufferschicht die Schritte 13a) bis 13d) mindestens einmal wiederholt werden.

17. Verfahren nach einem der Ansprüche 13 bis 16, **dadurch gekennzeichnet, dass** in mindestens einer Beschichtungslösung zirkonverbindungen, vorzugsweise Zirkonium(IV) - (2,4) pentandionat und/oder Lanthanverbindungen, vorzugsweise Lanthan (III) - (2,4) pentandionat und/oder Seltenerdverbindungen, vorzugsweise Cer(III)acetylacetonat, verwendet werden.

18. Verfahren nach einem der Ansprüche 1 bis 17, **dadurch gekennzeichnet, dass** als Substrat ein texturiertes, nicht ferromagnetisches Metallband, vorzugsweise aus einer Ni-Wo Legierung oder Ni-Mn Legierung verwendet wird.

19. Verfahren nach einem der Ansprüche 1 bis 18, **dadurch gekennzeichnet, dass** auf die letzte HTSL-Schicht eine Funktionsschicht aus Metall aufgebracht wird.

20. Verfahren nach einem der Ansprüche 1 bis 19, **dadurch gekennzeichnet, dass** eine HTSL-Schicht dicker als 500nm, vorzugsweise dicker als 900nm, besonders bevorzugt dicker als 1000nm hergestellt wird.

## Claims

1. Method for manufacturing a strip-shaped high-temperature superconductor (HTSC) from a substrate on which a buffer layer is present onto which at least two HTSC precursor layers are deposited, comprising the steps of:
(a) preparing an HTSC precursor solution,
(b) depositing the HTSC precursor solution,
(c) drying,
(d) pyrolysis,
(e) heat treatment for producing a superconducting layer,
in which the steps (a) to (d) are repeated at least once, and the concentration of fluorine components in the HTSC precursor solution is increased from layer to layer, i.e. by using precursor solutions that at first are poor in fluorine, and later rich in fluorine.

2. Method according to claim 1, **characterized in that** the first HTSC precursor solution to be deposited is free from fluorine.

3. Method according to any one of claims 1 or 2, **characterized in that** propionic acid, and/or pivalic acid, and/or methanol, and or toluene are used as a solvent for at least one HTSC precursor solution

4. Method according to any one of claims 1 to 3, **characterized in that** the heat treatment in step 1(e) is effected at temperatures below the melting temperature of the HTSC.

5. Method according to any one of claims 1 to 4, **characterized in that** Y(III) and/or Ho(III)-Cu(II) trimethylacetate, and/or barium hydroxide octahydrate are used for preparing at least one precursor solution.

6. Method according to claim 5, **characterized in that** at least one HTSC precursor solution having a molarity of about 0.1 to 0.5 based on rare earth metals is used.

7. Method according to any one of claims 1 to 6, **characterized in that** trifluoroacetic acid is used for preparing at least one HTSC precursor solution.

8. Method according to any one of claims 1 to 7, **characterized in that** at least one HTSC precursor solution containing trifluoroacetate is used.

9. Method according to any one of claims 5 to 8, **characterized in that** at least one HTSC precursor solution that is poor in fluorine is used, the fluorine content of which is insufficient for complete saturation of the Ba ions, this HTSC precursor solution preferably containing less than 6 moles of fluorine per mole of YBCO.

10. Method according to any one of claims 5 to 9, **characterized in that** at least one HTSC precursor solution that is rich in fluorine and has a fluorine content of at least 30 moles of fluorine per mole of YBCO is used.

11. Method according to any one of claims 1 to 10, **characterized in that** at least one further buffer layer is deposited on the substrate before step 1 (a).

12. Method according to claim 11, **characterized in that** the buffer layer, or the last buffer layer in the case of more than one buffer layer, is substantially textured on at least its boundary face with the HTSC layer.

13. Method according to any one of claims 1 to 11, **characterized in that** the buffer layer, or at least one buffer layer in the case of more than one buffer layer, is deposited before step 1(a) by
(a) preparing a coating solution containing a polar solvent having at least one free hydroxyl group,
(b) applying the coating solution onto the metal substrate,
(c) drying, and
(d) producing the buffer layer by annealing treatment.

14. Method according to claim 13, **characterized in that** at least one buffer layer is produced that consists of zirconates, preferably La₂Zr₂O₇, and/or rare earth oxides, preferably CeO₂ / Gd₂O₃ and/or Y₂O₃, and that the buffer layer has a texture which in a RHEED measurement performed before deposition of an HTSC layer results in discrete reflexes and not exclusively in diffraction rings.

15. Method according to claim 13 or 14, **characterized in that** a carboxylic acid, preferably propionic acid, is used as a polar solvent having at least one free hydroxyl group.

16. Method according to any one of claims 13 to 15, **characterized in that** the steps 13(a) to 13(d) are repeated at least once before depositing an HTSC layer onto the buffer layer.

17. Method according to any one of claims 13 to 16, **characterized in that** zirconium compounds, preferably zirconium(IV) 2,4-pentanedionate, and/or lanthanum compounds, preferably lanthanum(III) 2,4-pentanedionate, and/or rare earth compounds, preferably cerium(III) acetylacetonate, are used in at least one coating solution.

18. Method according to any one of claims 1 to 17, **characterized in that** a textured non-ferromagnetic metal strip, preferably of an Ni-Wo alloy or Ni-Mn alloy, is used as a substrate.

19. Method according to any one of claims 1 to 18, **characterized in that** a functional layer of metal is deposited on the last HTSC layer.

20. Method according to any one of claims 1 to 19, **characterized in that** an HTSC layer is produced that is thicker than 500 nm, preferably thicker than 900 nm, and most preferably thicker than 1000 nm.

## Revendications

1. Procédé de fabrication d'un supraconducteur à haute température en forme de bande (SCHT) constitué d'un substrat, sur lequel se trouve une couche tampon, sur laquelle au moins deux couches de précurseur de SCHT sont appliquées dans les étapes suivantes:
a) préparation d'une solution de précurseur de SCHT,
b) application de la solution de précurseur de SCHT,
c) séchage,
d) pyrolyse,
e) traitement thermique pour générer une couche supraconductrice,
les étapes a) à d) étant répétés au moins une fois et la concentration en composants au fluor de la solution de précurseur de SCHT étant augmentée de couche en couche, c'est-à-dire que d'abord des solutions de précurseur pauvres en fluor et ensuite des solutions de précurseur riches en fluor sont utilisées.

2. Procédé selon la revendication 1, **caractérisé** en ceci que tout d'abord une solution de précurseur de SCHT exempte de fluor est appliquée.

3. Procédé selon une des revendications 1 ou 2
**caractérisé** en ceci que comme solvant pour au moins une solution de précurseur de SCHT on utilise de l'acide propionique et/ou de l'acide pivalique et/ou du méthanol et/ou du toluène.

4. Procédé selon une des revendications 1 à 3,
**caractérisé** en ceci que le traitement thermique de l'étape 1 e) s'effectue à des températures inférieures à la température de fusion du SCHT.

5. Procédé selon une des revendications 1 à 4,
**caractérisé** en ceci que pour la préparation d'au moins une solution de précurseur de SCHT on utilise de l'Y(III) et/ou du Ho(III)-Cu(II)- triméthylacétate et/ou de l'hydroxyde de barium-octahydrate.

6. Procédé selon la revendication 5, **caractérisé** en ceci qu'on utilise au moins une solution de précurseur de SCHT à env. 0,1 à 0,5 moles en ce qui concerne les métaux des terres rares.

7. Procédé selon une des revendications 1 à 6,
**caractérisé** en ceci qu'on utilise pour la préparation d'au moins une solution de précurseur de SCHT de l'acide trifluoracétique.

8. Procédé selon une des revendications 1 à 7,
**caractérisé** en ceci qu'on utilise au moins une solution de précurseur de SCHT contenant du trifluoracétate.

9. Procédé selon une des revendications 5 à 8,
**caractérisé** en ceci qu'on utilise au moins une solution de précurseur de SCHT pauvre en fluor, dont la teneur en fluor ne suffit pas à la saturation complète des ions Ba, ladite solution de précurseur de SCHT contenant de préférence moins de 6 moles de fluor par mole d'YBCO.

10. Procédé selon une des revendications 5 à 9,
**caractérisé** en ceci qu'on utilise au moins une solution de précurseur de SCHT riche en fluor, dont la teneur en fluor est d'au moins de 30 moles de fluor par mole d'YBCO.

11. Procédé selon une des revendications 1 à 10,
**caractérisé** en ceci qu'avant l'étape 1a) au moins une couche tampon supplémentaire est appliquée sur le substrat.

12. Procédé selon la revendication 11, **caractérisé** en ceci que la couche tampon, s'il y a plus d'une couche tampon, la dernière couche tampon est en grande partie texturée, au moins à leur surface limite avec la couche SCHT.

13. Procédé selon une des revendications 1 à 11,
**caractérisé** en ceci que la couche tampon, s'il y a plus d'une couche tampon, au moins une des couches tampon, est appliquée avant l'étape 1a) en
a) préparant une solution d'enduction contenant un solvant polaire ayant au moins un groupe hydroxyle libre,
b) appliquant la solution d'enduction sur le substrat métallique,
c) séchant et
d) générant la couche tampon par recuit.

14. Procédé selon la revendication 13, **caractérisé** en ceci qu'est généré au moins une couche tampon, laquelle est en zirconate, de préférence en La₂Zr₂O₇ et/ou en dioxydes de terres rares, de préférence CeO₂/Gd₂O₃ et/ou Y₂O₃, et que la couche tampon comporte une texturation qui entraîne lors d'une mesure REED avant application d'une couche SCHT des réflexions discrètes et non des anneaux de diffraction.

15. Procédé selon la revendication 13 ou 14,
**caractérisé** en ceci que comme solution polaire ayant au moins un groupe hydroxyle libre on utilise un acide carbonique, de préférence de l'acide propionique.

16. Procédé selon une des revendications 13 à 15,
**caractérisé** en ceci qu'avant l'application d'une couche SCHT sur la couche tampon les étapes 13a) à 13d) soient répétés au moins une fois

17. Procédé selon une des revendications 13 à 16,
**caractérisé** en ceci que, dans au moins une des solutions d'enduction, on utilise des composés du zircon, de préférence du zirconium(IV) (2,4) pentanedionate et/ou des composés du lanthane, de préférence du lanthane(III) (2,4) pentanedionate et/ou des composés de métaux des terres rares, de préférence du Cer(III) acétylacétonate.

18. Procédé selon une des revendications 1 à 17,
**caractérisé** en ceci que comme substrat, on utilise une bande métallique texturée, non ferromagnétique, de préférence en alliage de Ni-WO ou de Ni-Mn.

19. Procédé selon une des revendications 1 à 18,
n**caractérisé** en ceci que sur la dernière couche SCHT, une couche fonctionnelle en métal est appliquée.

20. Procédé selon une des revendications 1 à 19,
**caractérisé** en ceci qu'une couche SCHT plus épaisse que 500 nm, de préférence plus épaisse que 900 nm, et de préférence particulière plus épaisse que 1000 nm est générée.
